# FASCICULE DE BREVET EUROPEEN

(11) **EP 1 145 085 B1**
(45) Date de publication et mention de la délivrance du brevet: **17.09.2008**
(21) Numéro de dépôt: 00972529.2
(22) Date de dépôt: 13.11.2000
(51) Int. Cl.: G04G 1/00, G04G 17/08

(54) **MONTRE-BRACELET ELECTRONIQUE COMPORTANT UN CIRCUIT IMPRIME INCORPORE DANS UN BRACELET SOUPLE**
ELEKTRONISCHE ARMBANDUHR MIT EINER, IN EINEM BIEGSAMEN ARMBAND, EINGEBAUTEN LEITERPLATTE
ELECTRONIC WRIST WATCH COMPRISING AN INTEGRATED CIRCUIT INCORPORATED IN A FLEXIBLE BAND

(30) Priorité: 11.11.1999 CH 206199
(43) Date de publication de la demande: 17.10.2001
(73) Titulaire: The Swatch Group Management Services AG, 2501 Biel (CH)
(72) Inventeur: SILVANT, Olivier, CH-2532 Macolin (CH); MÜLLER, Jacques, CH-2732 Reconvilier (CH)
(74) Mandataire: Laurent, Jean
(86) Numéro de dépôt international: PCT/CH2000/000604
(87) Numéro de publication internationale: WO 2001/035173

(56) Documents cités:
- DE-U- 8 703 843
- FR-A- 2 240 475
- GB-A- 2 148 617
- GB-A- 2 201 266
- US-A- 4 255 801
- US-A- 4 412 751

## Description

La présente invention concerne une montre-bracelet électronique comportant un bracelet souple ayant un corps en élastomère moulé, un mouvement d'horlogerie électronique comportant des composants montés sur un film flexible à circuits imprimés, lesdits composants et le film flexible étant incorporés dans le corps du bracelet par surmoulage de l'élastomère dudit corps, une unité d'affichage commandée par le mouvement d'horlogerie, et une source d'alimentation électrique connectée au mouvement d'horlogerie. L'invention concerne aussi un procédé de fabrication d'une telle montre-bracelet.

Dans la demande de brevet français No 2 595 480, il est prévu une montre-bracelet de ce genre, comportant une unité d'affichage à cristaux liquides ou similaire, commandée par un circuit électronique alimentée par une pile ou une autre source d'alimentation électrique. Les éléments constitutifs du circuit électronique et l'unité d'affichage elle-même sont incorporés dans le bracelet, qui est fabriqué en matière plastique flexible ou similaire par surmoulage sur ces éléments sous forme d'une bande plate de faible épaisseur, l'écran d'affichage étant situé dans la partie médiane de ce bracelet. Le logement de la pile est ménagé dans une partie plus épaisse située à l'une des extrémités du bracelet, qui peut porter un élément de fermeture de celui-ci. A proximité de l'écran d'affichage, il est prévu plusieurs touches sensitives de commande qui sont intégrées à l'intérieur du bracelet, mais dont la face supérieure affleure la face correspondante de celui-ci. L'écran d'affichage étant intégré dans le bracelet du fait du surmoulage de celui-ci, la face supérieure de l'écran doit affleurer la face supérieure du bracelet pour que les indications affichées soient visibles, à moins que le bracelet soit moulé en une matière plastique transparente permettant la lecture de l'affichage.

Avec une telle structure, on conçoit que la matière plastique utilisée pour le surmoulage doit être relativement tendre pour que le bracelet soit assez souple. En conséquence, les composants enrobés dans cette matière sont mal protégés contre des pressions extérieures et risquent d'être rapidement endommagés lorsque la montre est portée au poignet. Ceci peut expliquer le fait que ce genre de montre n'a pas rencontré de succès commercial jusqu'à présent.

Dans la demande de brevet britannique No 1 574 730, il est décrit une montre-bracelet dont le boîtier et le bracelet sont formés d'une seule pièce moulée, par exemple en polypropylène, ce bracelet étant raccordé au boîtier par des parties amincies qui forment des charnières flexibles. Le bracelet comporte des logements équipé de touches de commande qui sont reliées électriquement aux modules électroniques montés dans le boîtier par un film à circuits imprimés, lequel est noyé dans la matière plastique. La fabrication d'une telle montre est relativement complexe parce qu'elle nécessite le montage de multiples éléments dans le boîtier et les logements prévus dans le bracelet.

La présente invention vise à créer une montre-bracelet dans laquelle la plupart ou la totalité de composants électroniques sont noyés dans un bracelet souple, mais sont néanmoins à l'abri des dommages pouvant être causés par des influences extérieures durant un usage normal de la montre. En outre, cette montre devrait pouvoir être fabriquée à un coût très bas.

Dans ce but, l'invention concerne une montre-bracelet électronique du genre indiquée en préambule, caractérisée en ce qu'elle comporte une pluralité d'éléments extérieurs montés sur le corps du bracelet et reliés les uns aux autres de manière souple par le bracelet, au moins certains de ces éléments extérieurs étant des boîtiers disposés de façon à recouvrir et protéger des composants du mouvement d'horlogerie et l'unité d'affichage.

Ainsi, les éléments délicats de la montre, à savoir les composants du mouvement d'horlogerie et l'unité d'affichage, sont montés de manière économique dans ou sur le bracelet et sont protégés par des boîtiers suffisamment rigides, qui peuvent être extrêmement simples et peu coûteux tout en ayant un aspect extérieur attrayant. La montre-bracelet peut être complétée par d'autres éléments extérieurs, par exemple des éléments décoratifs ayant un aspect analogue à celui des boîtiers et répartis le long du corps du bracelet.

L'invention fournit en outre un procédé de fabrication avantageux d'une telle montre-bracelet, comprenant les étapes suivantes : on monte les composants du mouvement d'horlogerie sur le film flexible à circuits imprimés, lequel comporte des moyens de connexion électrique pour le relier à l'unité d'affichage et à la source d'alimentation; puis on réalise le corps du bracelet par surmoulage sur le film flexible et sur lesdits composants, à l'exception des moyens de connexion; puis on raccorde l'unité d'affichage et la source d'alimentation auxdits moyens de connexion et on fixe les éléments extérieurs sur le corps du bracelet.

D'autres caractéristiques et avantages de l'invention apparaîtront dans la description suivante d'une forme de réalisation préférée, présentée à titre d'exemple non limitatif en référence aux dessins annexés, dans lesquels :
- la figure 1 est une vue partielle en perspective d'une montre-bracelet selon l'invention,
- la figure 2 est une vue éclatée en perspective montrant les principaux éléments de la montre de la figure 1, et
- la figure 3 est une vue en perspective et en coupe longitudinale montrant certains éléments de la figure 2.

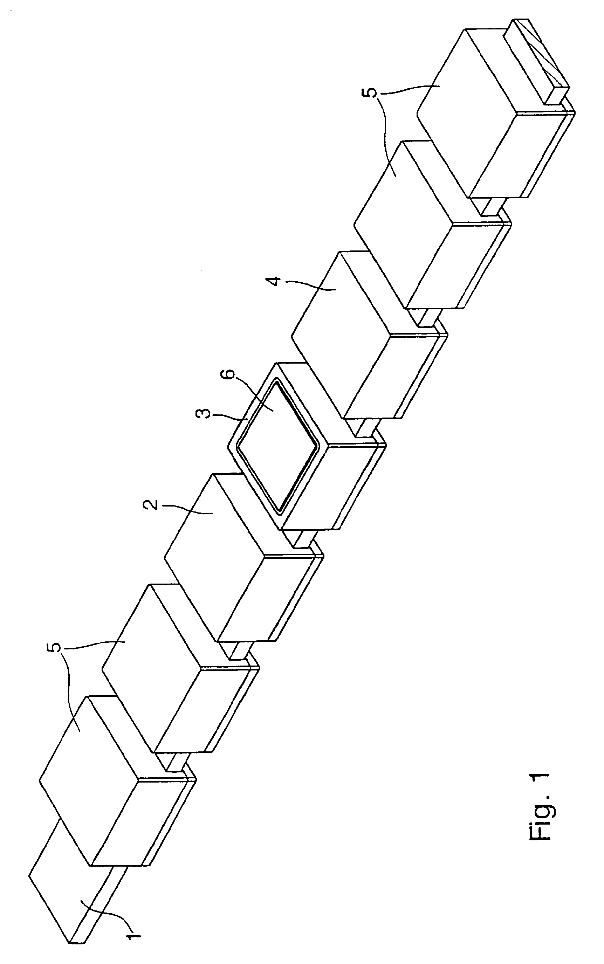

La montre-bracelet représentée à la figure 1 comporte un bracelet souple 1 sur lequel est montée une rangée d'éléments extérieurs comprenant des boîtiers 2, 3, 4 et des éléments décoratifs 5. Ces éléments extérieurs sont répartis le long du bracelet souple 1 qui les relie les uns aux autres et qui comporte à ses extrémités des moyens de fermeture classique non représentés, par exemple une boucle avec ardillon ou un fermoir pliant. Les éléments extérieurs 2 à 5 ont de préférence tous la même taille et peuvent être conformés pour donner à la montre-bracelet l'apparence d'un bracelet à maillons ou un autre aspect de fantaisie. Dans cet exemple, contrairement à une montre-bracelet classique, on ne remarque pas la présence d'un boîtier contenant tout le mouvement d'horlogerie à l'affichage, mais seulement une glace 6 disposée sur la face supérieure du boîtier 3 pour permettre de lire une unité d'affichage contenue dans ce boîtier.

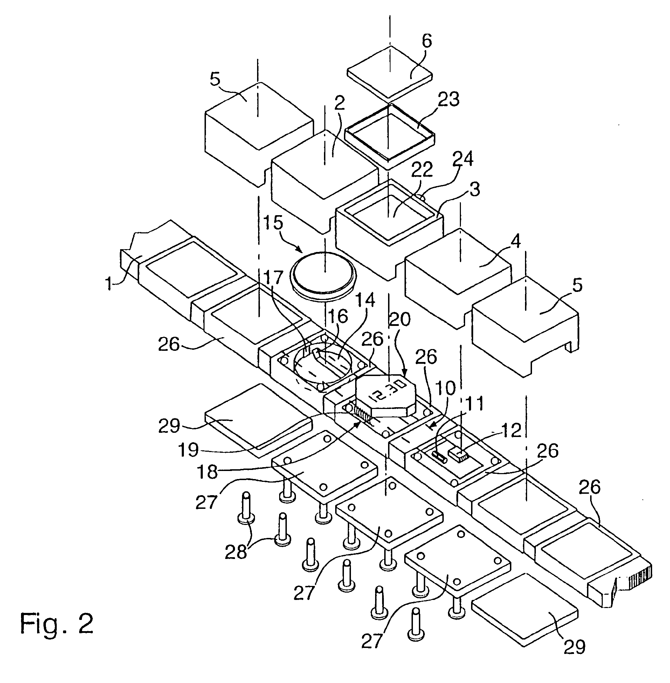

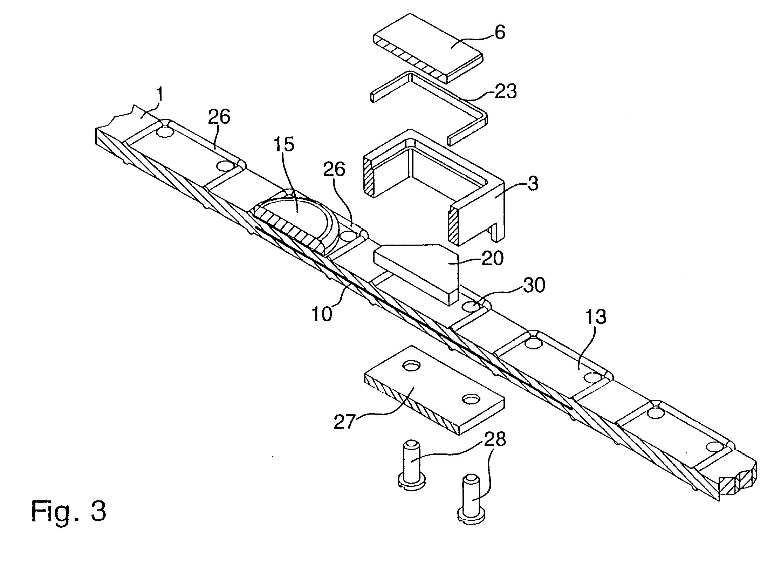

La structure interne de la montre-bracelet apparaît dans les figures 2 et 3. Le corps du bracelet 1 est formé par une bande moulée en matière thermoplastique électriquement isolante telle qu'un élastomère et contient un film flexible 10 à circuits imprimés qui, dans le présent exemple, s'étend dans la zone couverte par les trois boîtiers 2, 3 et 4, en particulier pour relier électriquement les éléments de la montre qui sont couverts par ces boîtiers. Sur ce film 10 sont montés la plupart et de préférence la totalité des composants du mouvement d'horlogerie, dont on voit par exemple un résonateur à quartz 11 et un circuit intégré 12 dans la figure 2, dans la zone couverte par le boîtier 4. On notera que dans cette zone la partie supérieure de l'élastomère, indiquée par la référence 13 dans la figure 3, a été supprimée dans la figure 2 de façon à laisser voir les composants 11 et 12, mais en réalité ils sont enrobés dans l'élastomère.

Dans la zone couverte par le boîtier 2, une cavité 14 est ménagée dans la partie supérieure du bracelet en élastomère pour recevoir la partie inférieure d'une pile électrique 15 servant de source d'alimentation électrique de la montre. Le film flexible 10 à circuits imprimés comporte dans cette zone deux lamelles de contact 16 et 17 qui émergent dans la cavité 14 pour s'appliquer contre les pôles correspondants de la pile 15 et relier celle-ci aux circuits imprimés.

Dans la zone couverte par le boîtier 3, le film flexible 10 comporte une languette de connexion 18 pourvue de pistes conductrices 19 pour relier les circuits imprimés à une unité d'affichage 20, constituée de préférence par une cellule d'affichage à cristaux liquides. L'unité 20 n'étant pas incorporée dans le corps en élastomère du bracelet 1, la languette de connexion 18 émerge de l'élastomère et elle est de préférence repliée pour être fixée au bord de l'unité 20 portant les contacts de commande de la cellule, par exemple au moyen d'une colle anisotrope. Dans l'exemple représenté, la languette 18 s'étend latéralement à partir du film flexible 10, mais on pourrait aussi prévoir qu'elle s'étende longitudinalement.

Alors que les boîtiers 2 et 4 sont complètement fermés dessus et sur les côtés, le boîtier central 3 a une ouverture supérieure 22 dans laquelle la glace 6 est montée à l'aide d'un joint d'étanchéité 23. Par ailleurs, le boîtier 3 ou l'un des deux autres boîtiers 2 et 4 est équipé d'un bouton-poussoir 24 permettant de commander diverses fonctions de la montre, en particulier la mise à l'heure, via les pistes 19 de la languette 18.

Les boîtiers 2, 3 et 4 sont ouverts vers le bas et conformés de manière à chevaucher le corps du bracelet 1, contre lequel ils sont appuyés de manière étanche grâce au fait que la nature compressible de l'élastomère lui permet de jouer le rôle d'une garniture d'étanchéité. Pour augmenter localement cette compressibilité, le corps du bracelet présente un bourrelet superficiel 26 sur sa face supérieure et ses faces latérales, en regard des surfaces des boîtiers 2 à 4 s'appuyant contre le bracelet. Chacun des boîtiers 2 à 4 est fixé sur le bracelet 1 à l'aide d'une plaque de fond respective 27 pourvue de trous à travers lesquels passent des vis 28 traversant des trous 30 du bracelet et s'engageant dans les parois latérales du boîtier. Ceci permet de serrer le corps du bracelet 1 entre la plaque et le boîtier pour garantir l'étanchéité.

Les éléments décoratifs 5 chevauchent le corps du bracelet 1 comme les boîtiers 2 à 4 et sont également fixés par serrage sur celui-ci à l'aide d'une plaque de fond respective 29. Comme il n'y a pas de souci d'étanchéité dans ce cas, la fixation de la plaque 29 à l'élément décoratif 5 n'a besoin d'être faite par des vis et peut aussi être réalisée, par exemple, par collage ou clipsage. On pourrait aussi prévoir que les éléments décoratifs aient une forme annulaire et soient enfilés sur le corps du bracelet 1.

Les boîtiers 2 à 4 et les éléments décoratifs 5 peuvent être faits de toute matière rigide ou semi-rigide, par exemple sous forme de pièces en matière plastique moulée ou injectée, dans le cas d'une montre peu coûteuse. Ils peuvent avoir une forme rectangulaire ou autre, en fonction des effets esthétiques recherchés, et des tailles identiques ou différentes. On remarque que l'invention permet de regrouper sous les boîtiers 2 à 4 tous les composants délicats de la montre et de les protéger ainsi contre des chocs, des pressions ou toute influence extérieure risquant de les endommager. Le film flexible 10 n'est pas entièrement protégé par les boîtiers, mais son enrobage par la matière élastomère du bracelet 1 lui offre une protection suffisante entre les boîtiers. On notera aussi que le boîtier 2 contenant la pile 15 peut être démonté facilement pour permettre de remplacer la pile.

Avec la structure décrite ci-dessus, la montre-bracelet peut être fabriquée par un procédé peu coûteux. De préférence, le film flexible 10 à circuits intégrés est obtenu par découpage d'une bande comportant un grand nombre de ces circuits. Les composants du mouvement d'horlogerie sont montés sur le film, soit avant, soit après le découpage de la bande. Ensuite, on effectue le surmoulage du corps en élastomère du bracelet 1 sur le film 10 équipé des composants électriques, en protégeant la languette de connexion 18 et les lamelles de contact 16 et 17 pour qu'elles émergent du corps en élastomère. Au besoin, le surmoulage peut être réalisé en plusieurs étapes, notamment pour faciliter le positionnement du film flexible dans le moule et/ou l'incorporation d'éléments de renfort tels que des fils ou un ruban textile formant une âme du bracelet. Le corps moulé peut comporter des éléments protubérants pour tenir l'unité d'affichage et la pile, par exemple par clipsage. L'unité d'affichage 20 peut être raccordée à la languette 18, soit avant le surmoulage, soit après. Ensuite, il suffit de mettre en place la pile 15 dans la cavité 14 et de monter sur le bracelet les boîtiers 2 à 4 et les éléments décoratifs 5, et procéder en outre au montage du fermoir du bracelet s'il y a lieu. On conçoit que ce mode de fabrication permet de produire la montre-bracelet d'une manière automatisée au maximum et à un coût très bas.

Dans le cadre de la présente invention, la construction décrite ci-dessus peut faire l'objet de multiples variantes. L'unité d'affichage peut être de n'importe quel type, notamment du type analogique à moteur pas à pas. La pile servant de source d'énergie électrique peut être remplacée par tout autre système d'alimentation approprié, par exemple à cellules solaires ou à microgénératrice entraînée par les mouvements du porteur de la montre. Les boîtiers protégeant les composants du mouvement d'horlogerie, l'affichage et la pile peuvent être plus ou moins nombreux. En particulier, on peut prévoir plusieurs affichages répartis dans plusieurs boîtiers, si la montre comporte diverses fonctions additionnelles. On peut également prévoir plusieurs boutons de commande, et ceux-ci peuvent être disposés soit sur les boîtiers, soit dans le corps du bracelet lui-même, par exemple en étant noyés dans l'élastomère. Bien entendu, les éléments décoratifs 5 ne sont pas indispensables dans le cadre de l'invention.

## Revendications

1. Montre-bracelet électronique comportant :
- un bracelet souple (1) ayant un corps en élastomère moulé;
- un mouvement d'horlogerie électronique comportant des composants (11, 12) montés sur un film flexible à circuits imprimés (10), lesdits composants et le film flexible étant incorporés dans le corps du bracelet par surmoulage de l'élastomère dudit corps;
- une unité d'affichage (20) commandée par le mouvement d'horlogerie; et
- une source d'alimentation électrique (15) connectée au mouvement d'horlogerie;
la montre-bracelet étant **caractérisée en ce qu'**elle comporte en outre une pluralité d'éléments extérieurs (2 à 5) montés sur le corps du bracelet (1) et reliés les uns aux autres de manière souple par le bracelet, au moins certains des éléments extérieurs étant des boîtiers (2 à 4) disposés de façon à recouvrir et protéger des composants (11, 12) du mouvement d'horlogerie et l'unité d'affichage (20).

2. Montre-bracelet selon la revendication 1, **caractérisée en ce que** la source d'alimentation électrique comporte une pile électrique (15) et **en ce que** l'un des éléments extérieurs est un boîtier (2) agencé pour recouvrir ladite pile.

3. Montre-bracelet selon la revendication 1 ou 2, **caractérisée en ce que** les boîtiers (2 à 4) sont appliqués de manière étanche contre le corps du bracelet, dont la matière élastomère constitue une garniture d'étanchéité.

4. Montre-bracelet selon la revendication 3, **caractérisée en ce que** le corps du bracelet comporte, en regard de chaque boîtier, un bourrelet superficiel (26) agencé pour s'appliquer de manière étanche contre le boîtier.

5. Montre-bracelet selon la revendication 3, **caractérisée en ce que** chaque boîtier (2 à 4) est agencé pour chevaucher le corps du bracelet, auquel il est fixé par serrage à l'aide d'une plaque de fond (27) disposée sous ledit corps.

6. Montre-bracelet selon la revendication 1 ou 2, **caractérisée en ce que** certains des éléments extérieurs, autres que lesdits boîtiers, sont des éléments décoratifs (5) répartis le long du corps du bracelet et reliés les uns aux autres de manière souple par le bracelet.

7. Montre-bracelet selon la revendication 6, **caractérisée en ce que** chaque élément décoratif (5) est agencé pour chevaucher le corps du bracelet, auquel il est fixé par serrage à l'aide d'une plaque de fond (29) disposée sous ledit corps.

8. Montre-bracelet selon la revendication 1, **caractérisée en ce que** le film flexible à circuits imprimés (10) comporte une languette de connexion (18) pourvue de pistes conductrices (19) pour le relier à l'unité d'affichage (20) et **en ce que** ladite languette émerge à l'extérieur du corps du bracelet.

9. Montre-bracelet selon la revendication 1, **caractérisée en ce que** le film flexible à circuits imprimés (10) comporte deux lamelles de contact (16, 17) pour le relier à la source d'alimentation (15) et **en ce que** lesdites lamelles émergent à l'extérieur du corps du bracelet.

10. Procédé de fabrication d'une montre-bracelet selon l'une des revendications précédentes, comprenant les étapes dans lesquelles :
- on monte les composants (11, 12) du mouvement d'horlogerie sur le film flexible à circuits imprimés (10), lequel comporte des moyens de connexion électrique (16, 17, 18) pour le relier à l'unité d'affichage (20) et à la source d'alimentation (15);
- on réalise le corps du bracelet (1) par surmoulage sur le film flexible et lesdits composants à l'exception desdits moyens de connexion; et
- on raccorde l'unité d'affichage et la source d'alimentation aux dits moyens de connexion; et
- on fixe lesdits éléments extérieurs (2 à 5) sur le corps du bracelet.

## Claims

1. Electronic wristwatch including:
- a flexible wristband (1) having a body made of moulded elastomer;
- an electronic watch movement including components (11, 12) mounted on a flexible printed circuit film (10), said components and said flexible film being incorporated in the body of the wristband by overmoulding of the elastomer of said body;
- a display unit (20) controlled by the watch movement; and
- an electric power source (15) connected to the watch movement;
the wristwatch being **characterised in that** it further includes a plurality of external elements (2 - 5) mounted on the body of the wristband (1) and connected to each other in a flexible way by the wristband, at least certain of said external elements being cases (2 - 4) arranged so as to cover and protect watch movement components (11, 12) and the display unit (20).

2. Wristwatch according to claim 1, **characterised in that** the electric power source includes an electric battery (15) and **in that** one of the external elements is a case (2) arranged to cover said battery.

3. Wristwatch according to claim 1 or 2, **characterised in that** the cases (2 - 4) are applied in a sealed manner against the body of the wristband, the elastomeric material of which forms a sealing gasket.

4. Wristwatch according to claim 3, **characterised in that** the body of the wristband includes, facing each case, a superficial rim (26) arranged to be applied in a sealed manner against the case.

5. Wristwatch according to claim 3, **characterised in that** each case (2 - 4) is arranged to overlap the body of the wristband, to which it is secured by being gripped via a bottom plate (27) disposed underneath said body.

6. Wristwatch according to claim 1 or 2, **characterised in that** certain of the external elements, apart from said cases, are decorative elements (5) distributed along the body of the wristband and connected to each other in a flexible way by the wristband.

7. Wristwatch according to claim 6, **characterised in that** each decorative element (5) is arranged to overlap the body of the wristband, to which it is secured by being gripped via a bottom plate (29) disposed underneath said body.

8. Wristwatch according to claim 1, **characterised in that** the flexible printed circuit film (10) includes a connection tongue (18) provided with conductive paths (19) to connect it to the display unit (20) and **in that** said tongue emerges outside the body of the wristband.

9. Wristwatch according to claim 1, **characterised in that** the flexible printed circuit film (10) includes two contact strips (16, 17) to connect it to the power source (15) and **in that** said strips emerge outside the body of the wristband.

10. Method for manufacturing a wristwatch according to any of the preceding claims, including the steps wherein:
- the watch movement components (11, 12) are mounted on the flexible printed circuit film (10), which includes electric connection means (16, 17, 18) for connecting it to the display unit (20) and the power source (15);
- the body of the wristband (1) is made by overmoulding on the flexible film and said components, with the exception of the connection means;
- the display unit and the power source are connected to said connection means;
- and said external elements (2 - 5) are fixed to the body of the wristband.

## Patentansprüche

1. Elektronische Armbanduhr, enthaltend:
- ein nachgiebiges Armband (1) mit einem aus Elastomer geformten Körper,
- ein elektronisches Uhrwerk mit Bauteilen (11, 12), die an einer biegsamen Leiterplattenfolie (10) angebracht sind, wobei die Bauteile und die biegsame Folie durch Anformen mit dem Elastomer des Körpers in dem Körper des Armbands eingegliedert sind,
- eine Anzeigeeinheit (20), die von dem Uhrwerk gesteuert wird, und
- eine Stromversorgungsquelle (15), die an das Uhrwerk angeschlossen ist,
wobei die Armbanduhr **dadurch gekennzeichnet ist, dass** sie ferner eine Mehrzahl von Außenteilen (2 bis 5) enthält, die an dem Körper des Armbands (1) montiert und über das Armband in nachgiebiger Weise miteinander verbunden sind, wobei zumindest bestimmte der Außenteile Gehäuse (2 bis 4) sind, die so angeordnet sind, dass sie Bauteile (11, 12) des Uhrwerks und die Anzeigeeinheit (20) abdecken und schützen.

2. Armbanduhr nach Anspruch 1, **dadurch gekennzeichnet, dass** die Stromversorgungsquelle eine elektrische Batterie (15) enthält und dass eines der Außenteile ein Gehäuse (2) ist, das dazu vorgesehen ist, die Batterie abzudecken.

3. Armbanduhr nach Anspruch 1 oder 2, **dadurch gekennzeichnet, dass** die Gehäuse (2 bis 4) in dichter Weise an den Körper des Armbands angedrückt werden, dessen Elastomermaterial einen Dichtungsbelag darstellt.

4. Armbanduhr nach Anspruch 3, **dadurch gekennzeichnet, dass** der Körper des Armbands einem jeden Gehäuse gegenüberliegend eine Oberflächenwulst (26) enthält, die dazu vorgesehen ist, in dichter Weise an das Gehäuse angedrückt zu werden.

5. Armbanduhr nach Anspruch 3, **dadurch gekennzeichnet, dass** jedes Gehäuse (2 bis 4) dazu vorgesehen ist, den Körper des Armbands zu überlappen, an dem es mit Hilfe einer unter dem Körper angeordneten Bodenplatte (27) festgeklemmt ist.

6. Armbanduhr nach Anspruch 1 oder 2, **dadurch gekennzeichnet, dass** bestimmte andere Außenteile als die Gehäuse dekorative Teile (5) sind, die entlang des Körpers des Armbands verteilt und über das Armband in nachgiebiger Weise miteinander verbunden sind.

7. Armbanduhr nach Anspruch 6, **dadurch gekennzeichnet, dass** jedes dekorative Teil (5) dazu vorgesehen ist, den Körper des Armbands zu überlappen, mit dem es mit Hilfe einer unter dem Körper angeordneten Bodenplatte (29) festgeklemmt ist.

8. Armbanduhr nach Anspruch 1, **dadurch gekennzeichnet, dass** die biegsame Leiterplattenfolie (10) eine Anschlusszunge (18) enthält, die mit Leiterbahnen (19) versehen ist, um sie mit der Anzeigeeinheit (20) zu verbinden, und dass die Zunge aus dem Körper des Armbands nach außen vorsteht.

9. Armbanduhr nach Anspruch 1, **dadurch gekennzeichnet, dass** die biegsame Leiterplattenfolie (10) zwei Kontaktlamellen (16, 17) enthält, um sie mit der Versorgungsquelle (15) zu verbinden, und dass die Lamellen aus dem Körper des Armbands nach außen vorstehen.

10. Verfahren zum Herstellen einer Armbanduhr nach einem der vorangehenden Ansprüche, das folgende Schritte umfasst:
- Anbringen der Bauteile (11, 12) des Uhrwerks an die biegsame Leiterplattenfolie (10), welche elektrische Verbindungsmittel (16, 17, 18) enthält, um sie mit der Anzeigeeinheit (20) und mit der Versorgungsquelle (15) zu verbinden,
- Herstellen des Körpers des Armbands (1) durch Anformen auf die biegsame Folie und die Bauteile, mit Ausnahme der Verbindungsmittel, und
- Anschließen der Anzeigeeinheit und der Versorgungsquelle an die Verbindungsmittel, und
- Befestigen der Außenteile (2 bis 5) an den Körper des Armbands.
